# EUROPEAN PATENT SPECIFICATION

(11) **EP 1 835 533 B1**
(45) Date of publication and mention of the grant of the patent: **03.06.2020**
(21) Application number: 06290421.4
(22) Date of filing: 14.03.2006
(51) Int. Cl.: H01L 21/762

(54) **Method for manufacturing compound material wafers and method for recycling a used donor substrate**
Verfahren zum Herstellen von zusammengesetzten Hableiterscheiben und Verfahren zur Wiederverwendung des gebrauchten Substrats
Méthode de fabrication de plaquettes composites et procédé de recyclage d'un substrat donneur usagé

(43) Date of publication of application: 19.09.2007
(73) Proprietor: Soitec, 38190 Bernin (FR)
(72) Inventor: Delprat, Daniel, 38920 Crolles (FR); Neyret, Eric, 38360 Sassenage (FR); Kononchuk, Oleg, 38000 Grenoble (FR); Reynaud, Patrick, 38400 Saint Martin d'Here (FR); Stinco, Michael Lotissement les balcons du Guiers, 73330 Pont-de-Beauvoisin (FR)
(74) Representative: Grünecker Patent- und Rechtsanwälte PartG mbB

(56) References cited:
- EP-A- 1 087 041
- EP-A1- 1 137 069
- EP-A1- 1 571 693
- US-A1- 2003 219 957
- US-A1- 2004 187 769
- US-A1- 2005 112 845
- US-A1- 2005 202 658

## Description

The invention relates to a method for manufacturing compound material wafers according to the preamble of claim 1, and a method for recycling a used donor substrate obtained from a method for manufacturing compound material wafers.

Compound material wafers, in particular, silicon on insulator (SOI) type wafers, as shown in US 2005/0202658 A1, US 2004/0187769 A1, US 2005/0112845 A1 and EP 1 087 041 A1, as a starting material in the semiconductor device manufacturing process are becoming more and more important. One way to obtain such wafers with good crystalline quality at reasonable cost, can be fabricated by transferring a layer from a donor substrate also of good crystalline quality onto a handle substrate, which is achieved by bonding the two substrates and detaching the donor substrate at a predetermined splitting area, which has previously been formed in the initial donor substrate. In the SmartCut™ type process, this formation of the predetermined splitting area is carried out by implanting atomic species, in particular hydrogen or rare gas ions, into the donor substrate, as shown in US 2003/0219957 A1 or in EP 1 571 693 A. The advantage of this process is that by doing so, the remainder of the donor substrate, which remains after the transfer of the layer onto the handle substrate, can be re-used as a donor substrate in a subsequent component material wafer fabrication process, as shown in EP 1 137 069 A1. Thus, one donor substrate can serve for several compound material wafers, like SOI type wafers.

It appeared, however, that the donor substrate could only be re-used three to four times, as from run to run, the crystalline quality of the donor substrate deteriorated. As a consequence, the crystalline quality of the final SOI substrate also deteriorated.

Generally, efforts have been made to allow the recycling of the used donor substrate. JP 10114176, for example, proposes to first polish the donor substrate to remove the surface step at the edge of the wafer which is present after the transfer of a layer onto the handle substrate and to carry out a second finishing polishing step before re-using the remainder of the donor substrate as a new donor substrate. US 6,211,041 not being directed to recycling processes, discloses a different approach which consists in providing, right from the beginning, a silicon substrate with an appropriate oxygen content to prevent the creation of crystal defects, which, according to the authors, are related to the presence of oxygen precipitates generated in the SOI device layer during the heat treatments which the wafers undergo during the SOI fabrication process.

It appeared, nevertheless, that still the number of possible re-uses of the donor substrate were still not satisfactory. In particular, it appears that controlling the initial oxygen content does not prevent the apparition of crystal defects in the final SOI layer after a multiple reuse.

It is therefore the object of the present invention to provide a method for manufacturing compound material wafers and/or a method for recycling used donor substrates used in a manufacturing process for compound material wafers which allow an increased number of re-uses of the used donor substrate and, at the same time, allow the fabrication of good quality compound material wafers at reasonable cost.

This object is achieved with the method for manufacturing compound material wafers according to claim 1.

The invention is characterized by the fact that it comprises at least one further treatment step which is configured such that oxygen precipitates and/or nuclei in the initial donor substrate and/or the remainder donor substrate are at least partially removed, in particular by dissolution. As the presence of the precipitates and/or nuclei is apparently linked to the creation of crystalline defects in the substrates, their dissolution during an additional thermal treatment allows the re-use of the donor substrate, and this more often than is the case today, as the creation of crystalline defects during re-use can be limited by the additional thermal treatment step.

The presence of oxygen nuclei in the wafers is attributed to the wafer fabrication process. During the ingot pulling, impurities are incorporated into the ingot. One of those is interstitial oxygen, which during pulling and cool down gathers to form nuclei. During subsequent heat treatments, typically in a range of 900°C to 1100°C the nuclei become precipitates due to diffusion of interstitial oxygen.

According to a preferred embodiment of the method for manufacturing compound material wafers, the remainder of the donor substrate can be re-used as initial donor substrate wherein steps b) to e) are repeated at least once before a first or further thermal treatment step is carried out. Depending on the rate of creation of oxygen precipitates and/or nuclei, the further thermal treatment step is thus carried out when necessary, to keep the amount of process steps low while at the same time ensuring a sufficiently high crystalline quality in the donor substrate or the remainder of the donor substrate, and consequently in the final SOI product.

The at least one of the at least one thermal treatments steps is a rapid thermal oxidation step. Surprisingly, the presence of oxygen leads to an improved removal of the oxygen precipitates and/or nuclei in the donor substrate. "Rapid" here means a temperature rise of at least 20°C/s, preferably at least 30°C/s, so that dissolution of the precipitates and/or nuclei takes place.

According to an advantageous embodiment, the rapid thermal oxidation step is carried out in a temperature range between 1150°C and 1300°C, and in particular, between 1200°C and 1250°C. In this temperature range, the oxygen precipitates and/or nuclei in the donor substrate can be, at least partially, reduced, in particular by dissolution.

Preferably, the rapid thermal oxidation step can be carried for a duration between 15 seconds to 5 minutes, in particular, for a duration of 30 seconds to 2 minutes, or for a duration between 1 minute to 5 hours if a batch anneal type furnace is used to carry out the rapid thermal oxidation step. To achieve the desired effect of reduction of oxygen, thus, both a single wafer furnace, as well as a batch type furnace can be used, so that the process can be easily adapted to the manufacturing process already in place.

Advantageously, the rapid thermal oxidation step can be carried out in an atmosphere having an oxygen concentration of at least 5% up to 100% and/or an oxygen rate of 5 to 20 liters per minute, and in particular, an oxygen rate of 10 liters per minute. For these concentrations, best results with respect to the removal of oxygen have been obtained.

According to the invention the rapid thermal oxidation step is carried out between step a) and b) and/or after step e). One of the advantages of the rapid thermal oxidation step is that it does not alter the surface roughness properties of the surface, so that a rapid thermal oxidation can already be carried out on the initial donor substrate before starting the manufacturing process. Thereby oxygen precipitates and/or nuclei already present in the substrate can already be removed at least partially. The advantage of using the rapid thermal oxidation step after step e), thus after the fabrication of the compound material wafer, has the advantage that oxygen precipitates and/or nuclei which have eventually been created during the heat treatment steps of the manufacturing process can be dissolved, and thus, reduced. Here oxygen precipitates and/or nuclei eventually created are removed after multiple donor wafer reuse to prevent the creation of crystalline defects in the final SOI layer.

Preferably, during the rapid thermal oxidation treatment, an oxide layer of a thickness in a range of 50 Å to 500 Å is grown on the initial donor substrate or the remainder of the donor substrate. Thus, the rapid thermal oxidation step does not only serve to remove oxygen in particular by dissolution, but at the same time provides a high quality thin oxide layer, which in a subsequent step serves as starting layer for the formation of the insulating layer, which usually is an oxide of the same type and which is usually thermally grown. This has the advantage that due to the fact that the quality of the thin oxide layer is high, also the insulating layer has good crystalline properties.

According to a preferred embodiment, the method for manufacturing compound material wafers can furthermore comprise, after step e), a further step f) comprising polishing of the surface of the donor substrate at which detachment occurred and wherein the rapid thermal oxidation step is carried out before and/or after step f). As the rapid thermal oxidation does not alter the quality of the surface, it can, as a consequence, be carried out prior to and/or after the polishing step. Eventually, it is also possible to have a rapid thermal oxidation step before and/or after the polishing step to keep the crystalline quality of the substrate high.

According to an alternative, which does not form part of the invention as claimed, at least one of the thermal treatment steps can be a rapid thermal anneal step, carried out in an oxygen free atmosphere. Such a treatment also reduces, in particular by dissolution, at least partially the precipitates and/or nuclei, but without creating an oxide layer. As a consequence, the object of being capable of re-using the donor substrate more often can also be achieved with a thermal treatment step without oxygen.

Advantageously, the thermal anneal step can be carried out in a hydrogen and/or argon atmosphere. In this atmosphere an optimized dissolution effect can be observed.

Preferably, the thermal anneal step is carried out between step a) and b) and or after step e) and is followed by a polishing step. Thus, even if the thermal anneal step deteriorates the quality of the surface of the donor substrate, it is possible to keep a sufficiently high surface quality due to the polishing step.

Preferably the method for manufacturing compound material wafers can be carried out such that the rapid thermal oxidation or anneal step is carried out with a temperature ramp of at least 20°C/s, in particular at least 25°C/s, when a batch furnace is used or with a temperature ramp of at least 30°C/s, in particular at least 50°C/s, when a single wafer furnace is used. For these temperature ramps the dissolution effect, independently of the use of a single wafer furnace or a batch type furnace the advantageous effects of the oxygen dissolution can be achieved.

Specific embodiments of the present invention will become more apparent from the present description with reference to the accompanying drawings wherein:
Fig. 1 illustrates a first embodiment of the inventive method for fabricating compound material wafers, and
Fig. 2 illustrates a second embodiment of the inventive method for manufacturing compound material wafers.

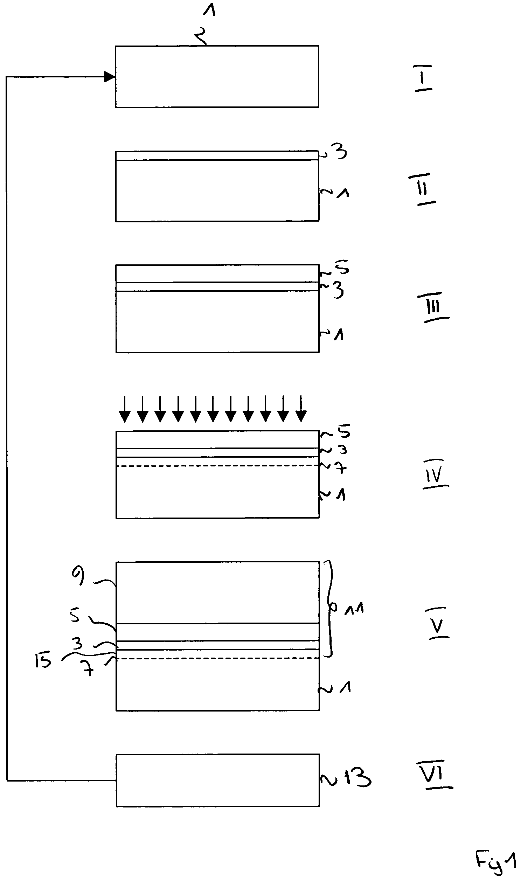

Fig. 1 illustrates a first embodiment of the inventive method of manufacturing compound material wafers. The method will be described for a silicon on insulator (SOI) type compound material wafer. This, nevertheless, only serves as an example and the inventive method is also applicable to other types of material compound wafers..

First of all, step I, corresponding to step a) of claim 1, consists in providing an initial donor substrate 1, here Si wafer. Then, in step II, a thermal treatment step according to the invention is carried out. In this embodiment, the thermal treatment step corresponds to a rapid thermal oxidation step, which leads to the creation of a thin silicon oxide layer 3 on top of the donor substrate 1.

To carry out the rapid thermal oxidation step, the donor substrate 1 is placed in an oxygen atmosphere with an oxygen rate of 5 to 20 liters per minute, and in particular, an oxygen rate of 10 liters per minute, and is brought to a temperature between 1000°C and 1300°C for in between 15 seconds to 5 minutes, and in particular, for a duration of 30 seconds to 2 minutes. In case a batch anneal type furnace is used, a plurality of donor substrates can be treated and the necessary thermal treatment is carried out for a duration between 1 minute and 5 hours. Under these conditions the atmosphere contains more than 5% oxygen and can even go up to 100% oxygen.

The thin silicon dioxide layer 3 typically grows up to a thickness of 50 Å to 500 Å and presents good crystalline properties and surface roughness.

In addition to growing the thin oxide layer 3, oxygen precipitates and/or nuclei which might be present in the donor substrate 1 are at least partially reduced by dissolution, so that the creation of crystalline defects in the donor substrate 1 due to the presence of oxygen can be suppressed at least to a large extent. During the rapid thermal oxidation step also crystalline defects which might be present in the part of the donor substrate which will be transferred later onto a handle substrate are eliminated. During the rapid thermal oxidation step oxygen precipitates and nuclei dissolve to essentially form interstitial oxygen.

Following step II, an insulating layer 5, preferably silicon dioxide, is thermally grown on the thin silicon dioxide layer 3 (step III). This layer will later on serves as the insulating layer in the silicon on insulator structure. This step corresponds to step b) of claim 1 and is known in the art.

In step IV, corresponding to step c) of claim 1, atomic species are implanted through the insulating layer 5 to create a predetermined splitting area 7, inside the donor substrate 1. Typically, the implanted atomic species are hydrogen and/or rare gas ions like helium, these species can be introduced by implantation or co implantation. The co implantation is realized in such a way that at least two different species, for example hydrogen and helium ions, are implanted sequentially, the helium being implanted preferably before the hydrogen.

The subsequent step V, corresponding to step d) of claim 1, consists in bonding a handle substrate 9, here a silicon wafer, to the insulating layer 5 on the donor substrate 1.

Then, a heat treatment is carried out during which detachment at the predetermined splitting area 7 occurs such that a silicon on insulator wafer 11 is created.

The remainder 13 of the donor substrate 1, thus without the layer 15, which has been transferred onto the handle substrate 9 to create the SOI wafer 11, is then recycled in step VI to prepare it for reuse. Here, the recycling step VI can consist in polishing and/or cleaning steps, like known in the prior art.

Then, the recycled remainder 13 of the donor substrate 1 can be reused as initial donor substrate 1, which is illustrated in Figure 1 by the arrow linking step VI and I.

According to a variant of the first embodiment, step II may not be carried out during each fabrication process, but only after every second, third or fourth, ect. run. This will depend on the amount of defaults created due to oxygen precipitates and/or nuclei, which can be created during the various heat treatments which the substrate will undergo during the fabrication process, e.g. the thermal oxide growth or the splitting step.

Instead of a silicon handle substrate 9, also other materials could be used, like quartz.

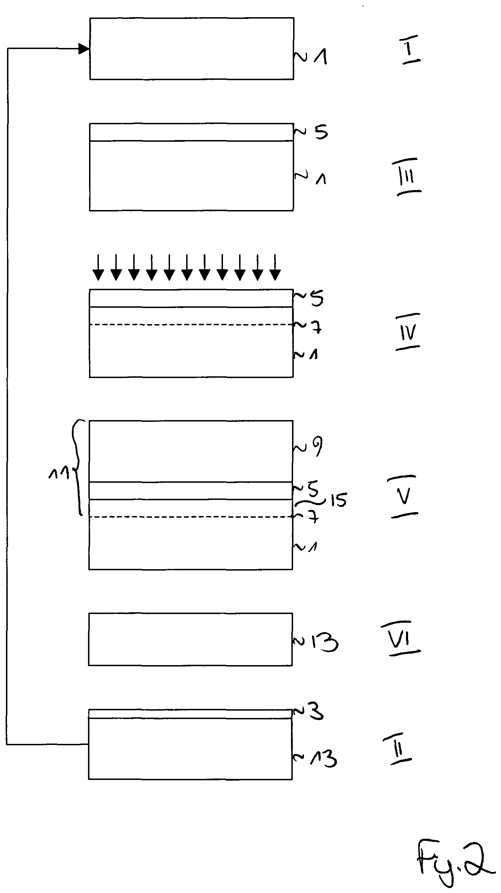

Fig. 2 illustrates a second embodiment of the method of manufacturing compound material wafers according to the invention. It differs from the first embodiment in that the rapid thermal oxidation step II is now carried out at the end of the manufacturing process instead of right at the beginning. Apart from the fact that during step III the thermal oxide is now formed directly on the initial donor substrate 1, which is a fresh substrate not having yet served in a manufacturing process, and not on the thin oxide layer 3 as in the first embodiment, the remaining steps IV, V and VI of the second embodiment corresponds to steps IV and V and VI of the first embodiment. Their description is therefore not repeated again in detail, but is incorporated herewith by reference. Of course instead of a fresh substrate a recycled substrate can be used, like mentioned further down.

Thus after detachment, like in the first embodiment, a remainder 13 of the donor substrate 1 is obtained. Then the recycling steps of polishing and/or cleaning and thereafter the rapid thermal oxidation step, process step II, are carried out. The oxidation step is carried out under the same conditions as disclosed with respect to the first embodiment, so that its description is incorporated herewith by reference.

By carrying out the oxidation step after the manufacturing of the SOI wafer 11, the oxygen precipitates and/or nuclei which were created during the thermal treatments can be dissolved at least partially during step II, so that in the subsequent re-use of the remainder 13 of the donor substrate 1 as a new initial donor substrate 1, a high crystalline quality can be provided in the next formed SOI layer 15.

Eventually, the recycling steps of cleaning and/or polishing can be carried out after the rapid thermal oxidation treatment or according to a further variant, a rapid thermal oxidation step can be carried out before and after the polishing and/or cleaning step.

Like in embodiment 1, the rapid thermal oxidation step is not necessarily carried out during each manufacturing process, but depending on the creation of oxygen precipitates and/or nuclei, it is only carried out every second, third, fourth ect. time in order to optimize the fabrication process.

According to the invention, steps VI and II of the second embodiment could also be considered as an independent recycling method of used donor substrates which were used in a fabrication process for creating compound material wafers wherein this fabrication comprises steps I, II, III and IV.

According to a third and fourth embodiment, which does not form part of the invention as claimed, a rapid thermal annealing step in an atmosphere not containing oxygen is carried out instead of a rapid thermal oxidation step II. Typically, such a process is carried out in a hydrogen and/or argon atmosphere with the same process parameters as those used for the rapid thermal oxidation step, except for the oxygen concentration. Also this heat treatment is suitable to reduce, at least partially, oxygen precipitates and/or nuclei by dissolution. However, as such a treatment negatively affects the surface quality, the anneal heat treatment step should preferably be followed by a polishing step to ensure sufficient surface roughness of the donor substrate 1. In the oxygen free atmosphere no thin oxide layer 3 will be formed.

It has been shown that by carrying out the additional heat treatment to reduce oxygen precipitates and/or nuclei, the amount of crystalline defaults in the end product, the SOI wafer 11, can be reduced by a factor of at least 6. This result has been proved by growing a silicon oxide layer with a thickness of 6000 Å on two silicon wafers. This thickness is equivalent to 4 x 1500 Å which is a typical thickness for the isolation layer 5 of a silicon on insulator wafer and aimed at simulating the thermal treatment of four layer transfers. Wherein for one wafer, no additional heat treatment, in particular the oxidation treatment, has been carried out, for the second wafer, the inventive additional heat treatment step has been carried out and an analysis of the defects showed the reduction in crystalline defects.

Unlike the prior art, in the method according to the invention, precipitates and/or nuclei are not prevented from creation, but are preferably removed during the process, as in fact their creation cannot be prevented, which is due to the fact that they are always created during the heat treatments which are part of the fabrication process.

As a consequence, the donor substrate, can be more often reused which makes the fabrication process cheaper, and at the same time the high quality of the transferred layer 15 onto the SOI wafer 11 can be assured.

## Claims

1. Method for manufacturing compound material wafers, in particular silicon on insulator type wafers, comprising the steps:
a) providing an initial donor substrate (1),
b) forming an insulating layer (5) over the initial donor substrate (1),
c) forming a predetermined splitting area (7) in the initial donor substrate (1),
d) attaching the initial donor substrate (1) to a handle substrate (9), and
e) detaching the donor substrate (1) at the predetermined splitting area (7), thereby transferring a layer (15) of the initial donor substrate (1) onto the handle substrate (9) to form a compound material wafer (11), and
further comprising at least one thermal treatment step configured to at least partially reduce, in particular by dissolution, oxygen precipitates and/or nuclei, in the initial donor substrate (1) and/or the remainder (13) of the donor substrate (1),
wherein the remainder (13) of the donor substrate (1) is reused as initial donor substrate (1), wherein steps b) to e) are repeated at least once before further thermal treatment step is carried out, and
wherein at least one of the at least one thermal treatment step is carried out between step a) and b); and **characterised in that** said at least one of the at least one thermal treatment steps is a rapid thermal oxidation step.

2. Method according to claim 1, wherein the thermal treatment is carried out in a temperature range between 1150°C and 1300°C, in particular between 1200°C and 1250°C.

3. Method according to claim 2, wherein the thermal treatment is carried out for a duration between 15 sec to 5 min, in particular for a duration of 30 sec to 2 min or for a duration between 1 min to 5 hrs in case a batch anneal type furnace is used to carry out the rapid thermal oxidation step.

4. Method according to one of claims 1 to 3, wherein the rapid thermal oxidation step is carried out in an atmosphere having an oxygen concentration of 5% to 100% and/or an oxygen rate of 5 to 20 l/min, in particular an oxygen rate of 10 l/min.

5. Method for manufacturing compound material wafers according to one of claims 1 to 4, wherein the rapid thermal oxidation step is carried out between step a) and b) and after step e).

6. Method according to claim 5, wherein during the rapid thermal oxidation treatment an oxide layer (3) of a thickness in a range of 50Å to 500Å is grown on the initial donor substrate (1) or the remainder (13) of the donor substrate (1).

7. Method for manufacturing compound material wafers according to one of claims 1 to 6, further comprising after step e) a step f) comprising polishing of the surface of the donor substrate (1) at which detachment occurred and wherein the rapid thermal oxidation step is carried out before and/or after step f).

8. Method for manufacturing compound material wafers according to one of claims 1 to 7, wherein the rapid thermal oxidation or anneal step is carried out with a temperature ramp of at least 20°C/s, in particular at least 25°C/s when a batch furnace is used or with a temperature ramp of at least 30°C/s, in particular at least 50°C/s, when a single wafer furnace is used.

## Patentansprüche

1. Verfahren zum Herstellen von Wafern aus Verbundmaterial, insbesondere von Siliziumauf-Isolator-Wafern, das die folgenden Schritte umfasst:
a) Bereitstellen eines ursprünglichen Donator-Substrats (1),
b) Ausbilden einer isolierenden Schicht (5) über dem ursprünglichen Donator-Substrat (1),
c) Ausbilden eines vorgegebenen Spalt-Bereiches (7) in dem ursprünglichen Donator-Substrat (1),
d) Aufbringen des ursprünglichen Donator-Substrats (1) auf ein Grundsubstrat (9), sowie
e) Ablösen des Donator-Substrats (1) in dem vorgegebenen Spalt-Bereich (7) und damit Übertragen einer Schicht (15) des ursprünglichen Donator-Substrats (1) auf das Grundsubstrat (9) zum Ausbilden eines Wafers(11) aus Verbundmaterial, und
wobei es des Weiteren wenigstens einen Wärmebehandlungs-Schritt umfasst, der so eingerichtet ist, dass er wenigstens teilweise, insbesondere durch Auflösung, Sauerstoff-Ausfällungen und/oder -Kerne in dem ursprünglichen Donator-Substrat (1) und/oder dem Rest (13) des Donator-Substrats (1) reduziert,
wobei der Rest (13) des Donator-Substrats (1) als ursprüngliches Donator-Substrat (1) wiederverwendet wird, und die Schritte b) bis e) wenigstens einmal wiederholt werden, bevor ein weiterer Wärmebehandlungs-Schritt durchgeführt wird, und
wobei wenigstens einer von dem wenigstens einen Wärmebehandlungsschritt zwischen Schritt a) und b) durchgeführt wird; und **dadurch gekennzeichnet, dass**
der wenigstens eine von dem wenigstens einen Wärmebehandlungs-Schritt ein Schritt schneller thermischer Oxidation ist.

2. Verfahren nach Anspruch 1, wobei die Wärmebehandlung in einem Temperaturbereich zwischen 1150°C und 1300°C, insbesondere zwischen 1200°C und 1250°C, durchgeführt wird.

3. Verfahren nach Anspruch 2, wobei die Wärmebehandlung über eine Dauer zwischen 15 s bis 5 min durchgeführt wird, insbesondere über eine Dauer von 30 s bis 2 min oder über eine Dauer zwischen 1 min bis 5 h, wenn ein Haubenglühofen zum Ausführen des Schrittes schneller thermischer Oxidation eingesetzt wird.

4. Verfahren nach einem der Ansprüche 1 bis 3, wobei der Schritt schneller thermischer Oxidation in einer Atmosphäre mit einer Sauerstoffkonzentration von 5% bis 100% und/oder einem Sauerstoffdurchsatz von 5 bis 20 l/min, insbesondere einem Sauerstoffdurchsatz von 10 l/min, durchgeführt wird.

5. Verfahren zum Herstellen von Wafern aus Verbundmaterial nach einem der Ansprüche 1 bis 4, wobei der Schritt schneller thermischer Oxidation zwischen Schritt a) und Schritt b) und/oder nach Schritt e) durchgeführt wird.

6. Verfahren nach Anspruch 5, wobei während der Behandlung zur schnellen thermischen Oxidation eine Oxidschicht (3) mit einer Dicke in einem Bereich von 50Å bis 500Å auf dem ursprünglichen Donator-Substrat (1) oder dem Rest (13) des Donator-Substrats (1) aufgewachsen wird.

7. Verfahren zum Herstellen von Wafern aus Verbundmaterial nach einem der Ansprüche 1 bis 6, das des Weiteren nach Schritt e) einen Schritt f) umfasst, der Polieren der Oberfläche des Donator-Substrats (1) umfasst, an der Ablösung stattgefunden hat, und wobei der Schritt schneller thermischer Oxidation vor und/oder nach Schritt f) ausgeführt wird.

8. Verfahren zum Herstellen von Wafern aus Verbundmaterial nach einem der Ansprüche 1 bis 7, wobei der Schritt schneller thermischer Oxidation oder zum Glühen mit einer Temperaturrampe von wenigstens 20 °C/s, insbesondere wenigstens 25 °C/s ausgeführt wird, wenn ein Chargenofen eingesetzt wird, oder mit einer Temperaturrampe von wenigstens 30 °C/s, insbesondere wenigstens 50 °C/s, wenn ein Single-Wafer-Ofen eingesetzt wird.

## Revendications

1. Procédé de fabrication de tranches de matériau composite, en particulier des tranches de type silicone sur isolant, comprenant les étapes suivantes :
a) l'utilisation d'un substrat donneur (1) initial,
b) la formation d'une couche isolante (5) par-dessus le substrat donneur (1) initial,
c) la formation d'une zone de séparation (7) prédéterminée dans le substrat donneur (1) initial,
d) la fixation du substrat donneur (1) initial à un substrat de manipulation (9), et
e) la séparation du substrat donneur (1) au niveau de la zone de séparation (7) prédéterminée, ce qui transfère ainsi une couche (15) du substrat donneur (1) initial sur le substrat de manipulation (9) pour former une tranche de matériau composite (11), et
comprenant en outre au moins une étape de traitement thermique configurée pour réduire au moins partiellement, en particulier par dissolution, des précipités et/ou des noyaux oxygénés dans le substrat donneur (1) initial et/ou dans le reste (13) du substrat donneur (1),
dans lequel le reste (13) du substrat donneur (1) est réutilisé comme substrat donneur (1) initial, les étapes b) à e) étant répétées au moins une fois avant qu'une autre étape de traitement thermique soit exécutée, et
dans lequel au moins l'une de la ou des étapes de traitement thermique est exécutée avant l'étape a) et l'étape b), et
**caractérisé en ce que**
ladite ou lesdites parmi la ou les étapes de traitement thermique est une étape d'oxydation thermique rapide.

2. Procédé selon la revendication 1,
dans lequel le traitement thermique est exécuté dans une plage de températures comprise entre 1150 °C et 1300 °C, en particulier entre 1200 °C et 1250 °C.

3. Procédé selon la revendication 2,
dans lequel le traitement thermique est exécuté pendant une durée comprise entre 15 secondes et 5 minutes, en particulier pendant une durée de 30 secondes à 2 minutes ou bien pendant une durée comprise entre 1 minute et 5 heures dans le cas où un four de type à recuit par lots est utilisé pour exécuter l'étape d'oxydation thermique rapide.

4. Procédé selon l'une des revendications 1 à 3,
dans lequel l'étape d'oxydation thermique rapide est exécutée dans une atmosphère comportant une concentration d'oxygène allant de 5 % à 100 %, et/ou un débit d'oxygène allant de 5 litres/minute à 20 litres/minute, en particulier un débit d'oxygène de 10 litres/minute.

5. Procédé de fabrication de tranches de matériau composite selon l'une des revendications 1 à 4,
dans lequel l'étape d'oxydation thermique rapide est exécutée entre l'étape a) et l'étape b) et après l'étape e).

6. Procédé selon la revendication 5,
dans lequel, pendant le traitement d'oxydation thermique rapide, une couche d'oxyde (3) d'une épaisseur située dans la plage allant de 50 Å à 500 Å est mise à croître sur le substrat donneur (1) initial ou sur le reste (13) du substrat donneur (1).

7. Procédé de fabrication de tranches de matériau composite selon l'une des revendications 1 à 6,
comprenant en outre, après l'étape e), une étape f) comprenant le polissage de la surface du substrat donneur (1) sur lequel s'est produite la séparation, et où l'étape d'oxydation thermique rapide est exécutée avant et/ou après l'étape f).

8. Procédé de fabrication de tranches de matériau composite selon l'une des revendications 1 à 7,
dans lequel l'étape d'oxydation thermique rapide ou de recuit est exécutée en utilisant une rampe de température d'au moins 20 °C/seconde, en particulier au moins 25 °C/seconde lorsqu'un four par lots est utilisé, ou bien en utilisant une rampe de température d'au moins 30 °C/seconde, en particulier d'au moins 50 °C/seconde lorsqu'un four pour tranche unique est utilisé.
